**Europäisches Patentamt**

**European Patent Office**

**Office européen des brevets**

(19)

(11) Veröffentlichungsnummer: **0 226 898 B1**

(12) **EUROPÄISCHE PATENTSCHRIFT**

(45) Veröffentlichungstag der Patentschrift: **26.08.92**

(21) Anmeldenummer: **86116802.9**

(22) Anmeldetag: **03.12.86**

Teilanmeldung 89121410.8 eingereicht am 03/12/86.

(51) Int. Cl.5: **B32B 15/02**, B32B 15/04, B32B 18/00, C23C 16/26, C23C 16/34, C23C 16/44, C23C 4/10, C23C 4/06, C23C 4/12

(54) **Verbundpulverteilchen, Verbundkörper und Verfahren zu deren Herstellung.**

(30) Priorität: **24.12.85 DE 3546113**

(43) Veröffentlichungstag der Anmeldung:
**01.07.87 Patentblatt 87/27**

(45) Bekanntmachung des Hinweises auf die Patenterteilung:
**26.08.92 Patentblatt 92/35**

(84) Benannte Vertragsstaaten:
**AT BE CH DE ES FR GB GR IT LI LU NL SE**

(56) Entgegenhaltungen:
**EP-A- 0 157 212
DE-A- 3 522 583
JP-A-59 137 311**

**Uhlmann Bd. 19 (4. Auflage), S 563, Verlag Chemie, 1980**

(73) Patentinhaber: **SUMITOMO ELECTRIC INDU-STRIES, LTD.
5-33, Kitahama 4-chome, Chuo-ku
Osaka-shi, Osaka 541(JP)**

(72) Erfinder: **Lux, Benno, Prof. Dr.
Brentsch-Park 85
CH-7550 Scuol/GR(CH)**

(74) Vertreter: **Weber, Dieter, Dr. et al
Dr. Dieter Weber und Dipl.-Phys. Klaus Seif-fert Patentanwälte Gustav-Freytag-Strasse
25 Postfach 6145
W-6200 Wiesbaden 1(DE)**

EP 0 226 898 B1

Chemical Abstracts, Band 101, Nr. 11, 10 Sep 1984, Columbus, Ohio, USA Sumitomo " Coating with cubic boron nitride alloy by vapor deposition " Seite 316, Spalte 2, Zussamenfassung-Nr. 96 212y

Journal of Applied Physics, Band 47, Nr.11, Nov. 1976 S.P.CHAUHAN " Kinetics of carbon deposition on diamond powder", Seiten 4746-4754

Zeitschrift Der Deutschen Gemmologischen Gesselschaft, Jahrgang 33, Heft 1/2, Juni 1984, Idar-Oberstein K.RECKER " Synthetische Diamanten ", Seiten 5-34

PATENT ABSTRACTS OF JAPAN, unexamined applications, field C, Band 9, Nr. 267, 24 OCT. 1985 THE PATENT OFFICE JAPANESE GOVERNMENT Seite 123 C 310

PATENT ABSTRACTS OF JAPAN, unexamined applications, field C, Band 9, Nr. 317, 12 Dec 1985 THE PATENT OFFICE JAPANESE GOVERNMENT Seite 2 C 319

CHEMICAL ABSTRACTS, Band 104, Nr. 18, 5 May 1986, Columbus, Ohio, USA SATO MAMORU " Coating of hard boron notride " Seite 351, Spalte 2, Zusammenfassung-Nr. 154 510u

**Beschreibung**

Mehrphasige Verbundpulverteilchen sind seit langem bekannt. Zum Beispiel sind Graphitpartikel mit dünnen Kupfer- oder Nickelschichten umhüllt sowie Umhüllung von Diamantpulvern mit z. B. dünnen Nickel- oder Kupferschichten oder Uranoxidteilchen mit Pyrokohlenstoff oder SiC-Schichten umhüllt in der Literatur beschrieben.

Der Vorteil derartiger Verbundpulver ist, daß sie, entweder als Pulver verwendet, besondere Oberflächeneigenschaften aufweisen, die vom Kernmaterial verschieden sind, oder durch Verpressen und Sintern zu mehrphasigen Körpern verarbeitet werden können, die besondere Eigenschaften haben.

Verfahren, derartige Pulver herzustellen, sind zum Beispiel chemische oder elektrolytische Abscheidung aus wäßriger Lösung bzw. Salzschmelzen oder Abscheidungen aus der Gasphase.

Auch epitaxisch abgeschiedene Diamantschichten auf Diamantpulvern wurden vor einiger Zeit beschrieben mit dem Ziel, das Gewicht des Diamantpulvers zu erhöhen. Besondere Änderungen der physikalischen und chemischen Eigenschaften des Diamantpulvers wurden dabei nicht beabsichtigt (S. P. Chauhan, J. C. Angus, N. C. Gardner: J. of Appl. Phys. 47, 1976, Seiten 4746 bis 4754).

Für die Herstellung von Diamant-Schichten sind in der Literatur neue Verfahren zur Abscheidung von Diamant im metastabilen Bereich, im Unterdruck, beschrieben worden (K. Recker: Z. Dt. Gemmol. Ges. Nr. 1/2, 1984, 5/34).

Auch die Herstellung von superhartem BN wird in der Literatur mit analogen Methoden erwähnt (S. Komatsu, K. Akashi, T. Yoshida, Paper number P-5-11, Proceedings of the JSPC-7 Eindhoven, July 1985).

In "Journal of Applied Physics", Band 47, Nr. 11 (1976), Sieten 4746 bis 4754 sind Versuche beschrieben, Kohlenstoff und/oder Diamant auf Diamantkernen abzuscheiden.

Die JP-A-59-137 311 beschreibt ein Verfahren zum Synthetisieren von polykristallinem Diamant in einem Vibrationsreaktor. Als Kerne für die Verbundmaterialteilchen wird Diamantpulver, Tantal, Molybdän oder $\alpha$-Aluminiumoxid verwendet.

Gemäß "Chemical Abstracts", Band 101, Nr. 11, Seite 316, Nr. 96 212y (1984) werden "Schneidwerkzeuge mit einem dünnen Bornitridfilm und gegebenenfalls Titan beschichtet. Die Vorrichtung gemäß "Patent Abstracts of Japan, unexamined applications", Feld C, Band 9, Nr. 317 (1985) dient der Beschichtung von Gegenständen nach dem CVD-Verfahren in einem insgesamt geheizten Reaktor, in den in einem Trägergas feine Teilchen von Siliciumcarbid, Zirkonoxid oder Aluminiumoxid eingeblasen werden.

Die der Erfindung zugrundeliegende Aufgabe bestand nun darin, unterschiedlich anwendbare Verbundmaterialteilchen eines Durchmessers bis zu mehreren 1000 $\mu$m mit verbesserten Eigenschaften zu bekommen.

Diese Aufgabe wird mit den erfindungsgemäßen Verbundmaterialteilchen gemäß Anspruch 1 gelöst.

Nach einer bevorzugten Ausführungsform besteht die Schale wenigstens teilweise aus einem superharten Stoff, der chemisch verschieden von dem Material des Kernes ist.

Bevorzugt haben die superharten Stoffe eine Härte von mehr als 4500, besonders mehr als 6000 Vickers. Vorzugsweise besteht der superharte Stoff der Schale aus Modifikationen von Kohlenstoff, Bornitrid oder anderen Phasen aus dem ternären System B, N, C, wobei diese Elemente als Hauptbestandteile auftreten. Einige in diesen Systemen auftretende Phasen oder Verbindungen können einzeln oder als Gemische oder als Übergangsstrukturen oder in der Form von Kirstallgittern mit interstitiell eingelagerten Atomen oder als Mischkristalle oder als Kristallstrukturen, die mit einem hohen Anteil von Gitterfehlern behaftet sind, diese Härte erreichen.

Beispielsweise besteht der innere Kern aus SiC, $B_4C$, WC, TiC, TaC, TiN, TaN, ZrN, AlN, $Si_3N_4$, $TiB_2$, $TaB_2$, WB, CaS, CeS, $MoSi_2$, $TiSi_2$, $Al_2O_3$, AlNO, AlCON, Ti(C, O), Zr(C, N, O), einem Metall, wie Cu, Ag oder Au, Legierungen, intermetallischen Phasen, Verbindungen normaler Härte, wie Oxiden und Oxidgemischen, Silicaten, Aluminaten, Spinellen oder Sufiden, Karbiden, Nitriden, Carbonitriden, Oxykarbiden, Siliciden, Boriden, Oxycarbonitriden, Hydriden, Aluminiden oder Ferriten, oder anorganischen Salzen.

Bei noch einer anderen bevorzugten Ausführungsform besteht die äußere Schale aus mehreren Schichten, wovon mindestens eine aus ein- oder polykristallinem Diamant und/oder einer anderen superharten Kohlenstoffmodifikation oder einer superharten Modifikation von Bornitrid oder einer superharten binären oder ternären Phase aus diesem System, B, N, C besteht, wobei dieser superharte Stoff eine zusammenhängende anhaftende Schicht bildet.

Weiterhin ist es zweckmäßig, wenn sowohl der Kern als auch die Schale aus einer superharten BN-Modifikation besteht, wobei diese sich chemisch und/oder physikalisch in ihrer Struktur und/oder ihren Eigenschaften unterscheiden.

Zweckmäßig kann es auch sein, daß der Kern so klein ist, daß er als ein heterogener Keim für die Kristallisation des Superhartstoffes aus der damit übersättigten Gasphase anzusehen ist. Mit gewissen, später näher beschriebenen Einschränkungen kann der Kern aus einer großen Reihe von Stoffgruppen frei ausgewählt werden. Der Kern kann auch aus einem superharten Stoff bestehen, der sich dann aber von den äußeren superharten Schichten der Umhüllung in seiner chemischen Zusammensetzung und/ oder in seinen physikalischen und/oder chemischen Eigenschaften mehr oder weniger stark unterscheidet.

Eine Reihe von Kombinationsmöglichkeiten für fast vollständig aus superharten Stoffen bestehende Pulver existiert.

1. Kombination:

Einkristalliner superharter Kern mit einkristalliner superharter Umhüllung mit vom Kern verschiedenen chemischen und/oder physikalischen Eigenschaften.

Obwohl die der Erfindung zugrundegelegte Umhüllung mit einem superharten Stoff normalerweise nicht einkristallin ist, kann dies erzwungen werden, und zwar insbesondere dann, wenn auch der Kern aus einem einkristallinen Teilchen besteht und die Schicht auf diesem Kern epitaxisches Wachstum zeigt. Das Wachstum dieser Umhüllungsschicht ist dann aber nicht gleichmäßig. Ihre Dicke ist von den Kernkristallflächen abhängig und je nach Unterlagsflächen unterschiedlich. Das heißt, gewisse Kristallflächen und Kristallorientierungen werden dicker belegt werden und andere dünner. Hochindizierte Flächen werden normalerweise stärker belegt. Kristallgleichgewichtsformen mit niedrig indizierten Flächen treten dadurch bevorzugt im äußeren Erscheinungsbild auf und können die äußere Gestalt (Habitus) der Pulverteilchen stark bestimmen.

2. Kombination:

Superharter Kern und chemisch gleichartige aber polykristalline, superharte Umhüllung.

Beispielsweise ist die Herstellung von superharten Bornitridschichten mit speziellen physikalischen Eigenschaften auf einem ein- oder polykristallinen superharten Bornitridkern möglich. Derartige Verbundpulver sind nicht nur für die weitere Verarbeitung zu einem Sinterprodukt von Interesse, sondern auch als Pulver selbst verwendbar.

Das Verfahren erlaubt aber auch, ohne hohen Druck durch eine Gasphasenreaktion als Umhüllung Diamant auf superharten Bornitridkernen herzustellen.

Ebenfalls ist es möglich, bei einem einkristallinen Kern anstelle der einkristallinen Schale eine polykristalline Schicht herzustellen, die z. B., als Pulver verwendet, beim Schleifen oder Polieren besonders griffig bleibt. Dabei kann eine teilweise epitaxische Beziehung zwischen dem Kern und der aufgewachsenen Schicht bestehen.

Die Schale unterscheidet sich vom Kern auch bei Verwendung der gleichen chemischen Substanz (z. B. BN), z. B. in ihrer chemischen Zusammensetzung, in ihren physikalischen Eigenschaften, in ihrem inneren Aufbau, z. B. der Zahl und der Art der Einschlüsse von Kristallfehlern und deren Dimension. Im Falle des Bestehens des Kerns und der Schale aus dem gleichen superharten Material kann zwar oft kein Unterschied in der Kristallstruktur vorliegen, aber trotzdem können absichtlich zur Erzielung gewisser besonderer Eigenschaften die chemische Zusammensetzung und/oder die physikalischen und/oder chemischen Eigenschaften der Schale stark geändert werden. Dies kann in extremen Fällen sogar zur Änderung der Kristallstruktur führen, was aber nur in Ausnahmefällen der Fall sein wird und keineswegs zur Erzielung der gewünschten Eigenschaftsveränderungen notwendig ist.

Wenn die Schale sich vom superharten Kern nur in den chemischen und/oder physikalischen Eigenschaften, jedoch nicht in seiner Kristallstruktur unterscheidet, können durch eine Änderung der Zusammensetzung oder der physikalischen Struktur der äußeren Schale besondere Eigenschaften des so erzeugten Verbundmaterials erzielt werden.

Es ist so möglich, entweder durch chemische Zusätze (Doping) Änderung sowohl der physikalischen als auch der chemischen Natur in die äußere Schale einzuführen, oder während der Bildung dieser superharten Diamantschicht durch besondere Abscheidungsbedingungen (Veränderung der Keimzahl und Wachstumsgeschwindigkeit durch Änderung der Abscheidungstemperatur oder besondere Sättigung des Gasraumes mit den reagierenden Komponenten oder durch eine besondere Beeinflussung (Beschleunigung) der Ionen etc.) deren Eigenschaften so zu verändern, daß diese deutlich von den ursprünglich eingesetzten Kernen abweichen. Es ist ferner möglich, durch diese Verfahren auch von idealem Diamantkristall stark abweichende fehlerhafte und verzerrte Kristallgitter zu erzeugen, bis hin zu Übergangsformen, die z. B. Einschlüsse von Lonsdaleit, d. h. ausgeprägte Stapelfehler des Gitters und sogar bis hin zu Strukturen, die der Stoffgruppe der Carbine angehören oder teilweise amorphe Strukturen zeigen.

Durch verschiedene Abscheidungsbedingungen sind dabei u. a. Eigenschaftsveränderungen möglich, die die Schale von relativ gut kristallisierten, kubischen Diamanten deutlich unterscheiden, beispielsweise:

1. Änderung der optischen Eigenschaften:

Farbe, z.B. blau (durch B-Zusätze), gelb-durchsichtig (durch $N_2$) oder braun bis schwarz (durch verschiedene Reinheitsgrade oder Verunreinigungen, z. B. durch Elemente wie Ni, Fe, Mn etc.). Damit verbunden sind z. B. bestimmte: Lichtbrechung, Lichtreflexion, Lichtszintilationseigenschaften, Röntgen-, Thermo-, Elektro- und Kathodoluminiszenz, z. B. mit verschiedenen Donor- und Akzeptorzentren, die durch Doping und/oder infolge Wachstumsfehler entstehen, anormale Doppelbrechung, Photoleitfähigkeit, UV- und/oder IR-Absorption oder Fluoreszenz und Phosphoreszenz.

2. Änderung der mechanischen, thermischen, morphologischen und anderer Eigenschaften, wie z. B.:

Dichte, Härte, Festigkeit, E-Modul, Spaltbarkeit, Abriebbeständigkeit und Abriebfestigkeit, thermische Leitfähigkeit, Bildung besonderer Kristallfacetten (z. B. ausschließlich Oktaederflächen oder Würfelflächen durch Zusätze von Mn, Zr, Platinmetalle etc. oder [113] Facetten, z. B. durch B-Zusätze, wie oft auf Ge- und Si-Kristallen beobachtet, Typ I Diamanten bzw. Ia oder Ib ähnliche Diamanten mit hohen Stickstoffgehalten oder anderen besonderen Verunreinigungen oder Typ II bzw. Typ IIa oder IIb Diamanten, z. B. durch besonders niedrige Stickstoffgehalte.

3. Änderungen von elektrischen Eigenschaften, wie:

elektrische Leitfähigkeit, Halbleitereigenschaft vom p-Typ (z. B. durch B-, Al- oder ähnlichen Zusatz oder Zusatz von freiem Kohlenstoff) mit besonderen Druck- und Temperaturabhängigkeiten, Halbleitereigenschaften vom n-Typ z. B. durch Legieren mit Stickstoff, P, As, Sb oder Li als Zwischengitter-Donoren und anderen geeigneten Elementen.

4. Änderung chemischer Eigenschaften, z. B.:

Benetzbarkeit durch flüssige Metalle, Legierungen etc., Benetzbarkeit durch oxidische und silicatische Schmelzen, Oberflächenreaktionsgeschwindigkeiten mit chemischen Stoffen, z. B. chemische Resistenz gegen oxidierende Medien, wie Sauerstoff, Salzschmelzen etc. oder reduzierende Medien, wie $H_2$, CO etc., Umwandlungskinetik (Geschwindigkeit) bei Erhitzen über 500 ° C der superharten metastabilen Modifikationen in die stabilen Modifikationen.

Im Falle von superhartem Bornitrid als Schale können analoge Eigenschaftsänderungen wie oben unter Punkt 1 bis 4 erzielt werden, wobei beispielsweise durch Zusatz von je 0,01 bis 5 Atom-% Se und/oder Te, vorzugsweise durch Zusatz von 0,15 bis 0,3 Atom-% dieser Elemente, halbleitende Eigenschaften mit einer Aktivierungsenergie im Bereich von 0,01 bis 0,5 eV, vorzugsweise von 0,1 bis 0,2 eV, durch Zusatz von 0,001 bis 2 Atom-%, vorzugsweise von 0,05 bis 0,5 Atom-% Sb p-Typ-Halbleiter erhalten werden.

Manche der hier aufgelisteten Eigenschaftsänderungen können zum Teil einzeln, zum Teil gemeinsam auftreten und ermöglichen eine starke Erweiterung der Nutzbarkeit derartiger mit Diamant bzw. superhartem BN umhüllter Verbundpulver.

3. Kombination:

Verbundmaterialteilchen bestehend aus wenigsten zwei chemisch verschiedenen superharten Stoffen als Kern oder Hülle (z. B. BN-Kern mit Diamant-Schicht.

Beispielsweise ist die Kombination von superhartem Bornitrid und superhartem Diamant von besonderem Interesse, da die beiden superharten Stoffe sich in ihren Polier-, Schleif- und Schneideigenschaften, z. B. gegenüber Stahl, Aluminium, Gesteinen und anderen Stoffen, wesentlich unterscheiden. Dabei ist die Schale eine ein- oder polykristalline superharte Modifikation des Kohlenstoffs und der Kern eine oder mehrere ein- oder polykristalline Phase(n) des superharten Bornitrids. Ebenso können hier alle anderen oben definierten Superhartstoffe mit Härten von über 3500 Vickers beliebig verwendet werden.

4. Kombination:

Superharter Kern mit superharter polykristalliner Schicht (chemisch gleich oder verschieden) sowie Ein lagerung ihrer stabilen Phasen in den Korngrenzen.

Eine weitere Möglichkeit ist, daß insbesondere bei den polykristallinen Schichten neben den superharten und metastabilen auch die normalen stabilen Phasen gleicher chemischer Zusammensetzung in gewissen Anteilen erzeugt werden können. Beispielsweise kann eine Umhüllungsschicht aus polykristallinem Diamant, in den Korngrenzen, je nach Herstellungsart, mehr oder weniger große Anteile von Graphit und/oder amorphem Kohlenstoff enthalten. Dies bringt beispielsweise bei jenen Anwendungen Vorteile, wo die Pulverteilchen nachträglich in einer Hochdruckpresse zu einem größeren Körper verdichtet werden. Dieser Graphitanteil hilft, vor seiner Hochdruckumwandlung in Diamant eine besonders dichte Packung des Preßkörpers zu erzeugen, da er im ersten Augenblick des Zusammenpressens zunächst ein Gleiten der

EP 0 226 898 B1

Körper untereinander und eine Verschiebung in sich ermöglicht, was die optimale Verdichtung erlaubt. Da der Graphit sehr fein verteilt ist, ist er in dieser Wirkung besonders günstig und besser geeignet als die dafür normalerweise zugesetzten Graphitpulveranteile.

Aber auch bei gewissen direkten Anwendungen der Verbundpulver zum Schleifen und Polieren hat der Graphitanteil eine positive Wirkung auf die Schleif- und Polierwirkung, da er infolge seiner Gleiteigenschaften und seiner besonderen Verteilung im Verbundkörper den Vorgang der Oberflächenglättung günstig beeinflußt.

Analoge Beispiele gelten für die superharten kubischen bzw. hexagonalen Bornitridphasen und die amorphen oder die normalerweise hexagonal auftretenden weichen Schichtstrukturen des Bornitrids. Auch hier kann die gleichzeitige Erzeugung dieser Nichthartstoffphasen durch geeignete Prozeßbedingungen gesteuert werden.

5. Kombination:

Kern mit einer oder mehreren äußeren superharten Schichten allein oder mit zusätzlichen normalen Schichten oder Hartstoffschichten.

Beispielsweise kann die Kombination von einem oder mehreren superharten Stoffen mit solchen Hartstoffen, die teilweise zum Polieren oder Schleifen heute bereits industriell genutzt werden (z. B. Aluminiumoxid, Siliciumcarbid, Borcarbid usw.), von besonderem Vorteil sein.

Dabei kann entweder nur der Kern ein normaler Hartstoff sein und ein einziger Superhartstoff die Schalen bilden, oder es können mehrere superharte Schichten aufgebracht werden, wobei als Zwischenlagen auch normale Stoffe oder Hartstoffschichten gewählt werden. In diesem Fall wird z. B. die Griffigkeit des superharten Stoffes, der in mehreren Lagen in der Schale aufgebracht wurde, durch eine Art Selbstschärfung erhöht, weil der zwar harte, aber doch vergleichsweise zum Süperhartstoff relativ weiche Hartstoff schneller abgerieben wird und damit der superharte Stoff immer eine scharfe Schneidkante für die Polier- oder Schleifarbeit darbietet. Durch Aufbringen in wechselnder Folge von superharten und harten Schichten ist dieser Effekt besonders ausgeprägt. Wichtig ist hierbei, daß die jeweilige Dicke der Schichten und ihre Härte in einem optimalen Verhältnis zueinander stehen. Je dünner die superharte Schicht, umso härter muß auch die Zwischenschicht der Hartstoffe sein, damit der sonst allzu rasche Verschleiß dieser Schicht nicht zu einem Ausbrechen und Abplatzen der superharten Schicht führt.

Die mehrlagige Aufbringung von superharten Stoffen in wechselnder Folge ermöglicht aber auch eine besonders feinkörnige Unterteilung dieser nach dem Verpressen und/oder Sintern in einem größeren Verbundkörper.

Auch die besondere chemische Resistenz oder andere Oberflächeneigenschaften der superharten Werkstoffe können hierbei genutzt werden.

Beim Verpressen derartiger mehrlagiger Verbundpulver können, z. B. besonders wenn als letzte äußerste Schicht eine besonders in Bezug auf ihre chemische Beständigkeit und Benetzung ausgewählte Schicht aufgebracht wird, die üblichen Vorteile der mehrphasigen Verbundpulverteilchen, wie gute Benetzbarkeit oder gute Kaltverschweißbarkeit oder besondere Resistenz gegenüber flüssigen Phasen bei der Herstellung usw., optimal genutzt werden.

6. Kombination:

Der Kern besteht aus einem winzigen Keim, auf dem der Superhartstoff aufgewachsen ist.

Dieser Keim kann aus einem artfremden Stoff bestehen und so klein sein, daß er praktisch nur schwer sichtbar gemacht werden kann oder arteigenes Material darstellen und nur aus einem sehr fehlerhaften Kristallgitter des superharten Stoffes selbst bestehen.

Im folgenden sind einige Stoffbeispiele aufgelistet, die zahlreiche weitere Kombinationen zeigen; denn der Erfindung entsprechend wird ein Verbundpulverteilchen hergestellt, bestehend aus einem in seiner Natur und seiner Größe sehr variablen inneren Kern, der von einer anhaftenden, vorzugsweise fest anhaftenden, äußeren Schale umhüllt wird. Diese besteht vollständig oder nur teilweise aus einem superharten Stoff und ist in ihren Dimensionen und in der Wahl der nicht superharten Zwischenschichten in weiten Bereichen variierbar. Derartige Zwischenschichten können im Prinzip aus dem gleichen Stoff wie die nachfolgend beschriebenen Kernmaterialien ausgewählt werden.

Das Verbundmaterialteilchen ist ferner charakterisiert dadurch, daß die Schale wenigstens eine Lage eines superharten Stoffes aufweist, wobei der Kern z. B. aus einer der oben aufgelisteten Substanzen besteht und wobei die äußere superharte Schale epitaxisch auf einem einkristallinen Kern aufgewachsen ist oder jede kristallographische Beziehung zwischen dem Kern und der ersten Schale fehlt, oder Übergänge zwischen den beiden Extremfällen in beliebigen Maß auftreten können oder die polykristalline Schale neben dem superharten Stoff den gleichen Stoff in seiner stabilen Modifikation enthält, weiche in der Korngrenze vorkommt, wobei, wenn der superharte Stoff Diamant oder Lonsdaleit oder eine andere superharte Kohlenstoffmodifikation ist, zusätzlich entweder (Graphit und/oder amorpher Kohlenstoff auftreten, und wenn

6

der Stoff eine superharte Modifikation von Bornitrid ist, zusätzlich entweder weiches hexagonales und/oder amorphes BN auftritt, oder die äußere Schale aus mehreren Schichten besteht, wovon mindestens eine aus kristallinem oder polykristallinem Diamant und/oder Lonsdaleit und/oder einer anderen superharten Kohlenstoffmodifikation besteht und diese eine zusammenhängende Schicht bilden, oder die äußere Schale aus mehreren Schichten besteht, wovon mindestens eine aus einkristallinen oder polykristallinen Modifikationen von superhartem Bornitrid besteht und dieses eine zusammenhängende Schicht bildet, oder die äußere Schale aus mehreren Schichten, die in regelmäßiger Reihenfolge abwechselnd immer wieder Zwischenschichten von Diamant und/oder superhartem Bornitrid enthalten, besteht, oder desgleichen, wobei in wechselnder unregelmäßiger Folge sowohl Diamantschichten als auch kubische Bornitridschichten verwendet werden, oder die äußeren Schichten neben Diamant und/oder superharten BN-Schichten und/oder anderen superharten binären oder ternären Phasen aus dem System B,N,C auch andere Schichten (z. B. die oben als Kern genannten anorganischen Stoffe) in der Schale des Verbundteilchens als Zwischenschicht enthalten.

Die Dimensionen des Verbundmaterialsteilchens sowie die Größe des Kernes bzw. der Umhüllung können in weiten Grenzen variiert werden, z. B. ist der Durchmesser des inneren Kernpartikels bei gewissen Pulvern, die alle für superharte Pulver heute übliche Durchmesser erreichen können, bei bewußt gewählten Versuchsbedingungen infolge homogener Keimbildung oder aus spontan sich bildenden Reaktionsprodukten (heterogene Keime) aus der stark übersättigten Gasphase sehr viel kleiner als 0,01 $\mu$m und daher praktisch auch mit den üblichen wissenschaftlichen Methoden nur schwer nachweisbar. Weist der Durchmesser des inneren Kernpartikelchens eine Größe von 0,01 bis 100 $\mu$m, vorzugsweise jedoch zwischen 1 und 10 $\mu$m, auf, liegt der äußere Durchmesser des Verbundmaterialteilchens zwischen 1 $\mu$m und mehreren 1000 $\mu$m, vorzugsweise aber im Bereich zwischen 10 und 100 $\mu$m, heben die einzelnen Schichten oder äußeren zusammenhängenden Schale jeweils eine Dicke zwischen,0,1 und 5000 $\mu$m, jedoch vorzugsweise zwischen 1 und 5 $\mu$m.

Auch der Aufbau ist variabel. Es können zum Beispiel die äußeren Schichten der Schale in gewisser Reihenfolge aufgebracht werden und zueinander in einem geordneten und regelmäßigen Verhältnis stehen, die in der äußeren Schale liegenden Schichtdicken des superharten Stoffes im Bereich zwischen 1 und 5 $\mu$m liegen, wobei die Hartstoffschichtdicke nur etwa die Hälfte bis ein Zehntel dieser Dicke betragen soll, die in der Schale liegenden Schichten des superharten Stoffes zwischen 100 und 500 $\mu$m liegen und der Hartstoff etwa gleich dick wie die Superhartstoffschicht sein.

Die erfindungsgemäßen Verbundmaterialteilchen werden zweckmäßig nach einem Wirbelschichtverfahren in Verbindung mit einem Gasphasenabscheidungsverfahren hergestellt. Allerdings muß das Verfahren in dem Sinne modifiziert werden, daß der Gasstrom, der die Pulverteilchen in Wirbelschichtbewegung hält, durch eine geeignete Vorbehandlung einen reaktiven und angeregten Gasanteil enthält, der die Entstehung der weichen und im Druck- und Temperaturbereich des Verfahrens thermodynamisch stabilen Phasen anstelle der metastabilen superharten Phasen verhindert. Insbesondere ist z. B. bei der Herstellung von Diamantschalen, ein entsprechend hoher Anteil eines reaktiven atomaren Wasserstoffatomes im Gas, sowie die Bildung von Kohlenstoffradikalen bzw. entsprechender Ionen von Bedeutung, da sonst weder der Diamant entsteht, noch die Bildung von unerwünschtem weichem Graphit oder von Kohlenstoffphasen verhindert bzw. kontrolliert werden kann.

Ähnliches gilt für die Herstellung der superharten Bornitridphasen. Durch eine geeignete Gasanregung müssen die Bor enthaltenden Gasmoleküle und/oder ein zweites Gas, wie z. B. Wasserstoff, Halogene oder Gemische daraus, in einen solchen Zustand gebracht werden, daß die Bildung der weichen hexagonalen Bornitridphase oder amorpher Phasen unterdrückt oder kontrolliert werden kann und die superharten Phasen als Hauptbestandteile oder ausschließlich abgeschieden werden. Die oben erwähnte Anregung und Herstellung entsprechen aggressiver Gase ($H_2$, Halogenide etc.) bzw. die Modifikation der Bor- bzw. Kohlenstoffverbindungen gelingt durch die Verwendung von Verfahren, die die gasförmigen Moleküle oder Atome entsprechend aufbricht und kurzlebige Ionen, Radikale oder atomare Gasspezien erzeugt. Dies kann auf verschiedene Art geschehen, beispielweise durch Erhitzen z. B. mit Hilfe einer glühenden Metalloberfläche, z. B. eines Ta- oder W-Drahtes, -Rohres oder -Netzes mit entsprechend hoher Temperatur, durch Gasentladungen im Unterdruck, ausgelöst von Gleich- oder Wechselströmen, durch die Anwendung eines kalten Plasmas, hergestellt durch elektromagnetische Wellen vorzugsweise im Mega- und Gigahertz-Bereich, durch Ultraschall bzw. Druckwechsel, durch die Verwendung rein chemischer Verfahren, wie z. B. durch Zersetzung von HJ oder HBr mit Licht, wobei die Bildung von atomarem Wasserstoff und Halogenen erzwungen wird. Werden dabei Stoffe verwendet, die als Endprodukt eine bei Reaktionstemperatur feste oder flüssige Phase bilden, so können diese als Kerne (heterogene Keime) des superharten Stoffes auftreten.

Derartige Anregungsverfahren sind zum Teil in den oben genannten Patenten enthalten und zum Teil auch in der älteren Literatur bereits erwähnt.

Es eignen sich insbesondere jene CVD-Verfahren zum Beispiel als Wirbelschichtverfahren oder CVD-Verfahren mit up-stream-Reaktoren, bei denen dieser Anregungszustand der Gase, bevor diese die Partikel z. B. in der Wirbelschicht erreichen, nicht zu stark verlorengeht und außerdem die in dem Normalzustand zurückgekehrten Gasmoleküle, nach ihrer Reaktion oder auch unverbraucht, möglichst geringe Konzentrationen in der Wirbelschicht erreichen. Das heißt, sie müssen aus dieser so rasch wieder entfernt werden, daß sie den Ablauf der gewünschten Reaktion nicht stören. Die Wirbelbettkonstruktion muß daher in Bezug auf die Verweilzeit der Gase den Bedürfnissen und der Kinetik der Abscheidungsreaktionen möglichst optimal angepaßt werden.

In Betracht zu ziehen sind unter anderem Verfahren zur Erzeugung von Verbundpulverteilchen mit Hilfe einer chemischen Gasphasenreaktion, Verfahren mit einer speziellen CVD-Reaktion in einem Upstream- oder Wirbelschichtreaktor, in welchem Partikel in Bewegung gehalten werden und in einem Gasstrom beschichtet werden können.

Die obigen Verfahren sind dadurch charakterisiert, daß sie für die Herstellung der Pulververbundteilchen ganz oder teilweise ein spezielles CVD-Verfahren, geeignet für die Herstellung von Superhartstoffen, einsetzen, wobei verwendet werden:

ein Gasstrom bestehend aus $CH_4$ oder einer anderen gasförmigen oder dampfförmigen Kohlenstoffverbindung sowie atomarem und molekularem Wasserstoff, sowie entsprechenden Ionen und Radikalen, die aus den Ausgangskomponenten entstehen können,

ein Gasstrom bestehend aus einer gas- oder dampfförmigen Borverbindung bzw. festen bzw. flüssigen Borverbindungen (z. B. Borhalogenide, Borane, Borazine, Bor-Mg-, Bor-Al-Verbindugnen), die solche bleiben können - mit oder ohne atomarem und molekularem Wasserstoff - und atomarem und molekularem Stickstoff, sowie entsprechenden Ionen und Radikalen, die aus den Ausgangskomponenten entstehen können,

ein Gasstrom bestehend aus einer gas- oder dampfförmigen Borverbindung (z. B. Borhalogenide, Borane, Borazine, Bor-Mg-, Bor-Al-Verbindungen etc.) - mit oder ohne atomarem und molekularem Wasserstoff - sowie atomarem und molekularem Stickstoff und/oder atomarem und molekularem Halogen oder Verbindungen dieser Stoffe, sowie Ionen und Radikalen, die aus den Ausgangskomponenten entstehen Können,

ein Gasstrom, der eine gas- oder dampfförmige Verbindung enthält, die neben anderen Atomen Bor- und Stickstoffatome als wesentliche Bestandteile aufweist, die bei starkem Erhitzen in BN zerfällt, und deren Gas oder Dampf in Verbindung mit anderen atomaren oder molekularen Gasen, wie Wasserstoff und/oder Stickstoff und/oder Halogen und/oder Edelgasen bzw. Verbindungen dieser Stoffe, Ionen, Radikale, atomare Spezien, die aus den Ausgangskomponenten dieser Mischung entstehen können, enthält.

Wenn in der Beschreibung oder den Ansprüchen von gas- oder dampfförmigen Kohlenstoffverbindungen die Rede ist, so sind damit organische Kohlenstoffverbindungen mit Wasserstoff und/oder Sauerstoff und/oder Stickstof und/oder Schwefel und/oder Phosphor gemeint.

Die Verfahren sind ferner dadurch charakterisiert, daß der Temperaturbereich, in dem sich die zu beschichtenden Pulver bewegen, zwischen 500 und 1200 °C liegt, die Beschichtung im Druckbereich unter 66,661 kPa (500 Torr), vorzugsweise im Bereich zwischen 66,661 Pa und 6,666 kPa (0,5 bis 50 Torr), betrieben wird, der Betrieb im diskontinuierlichen oder kontinuierlichen Betrieb geführt werden kann.

Eine spezielle Anwendung der nach dem erfindungsgemäßen Verfahren erhaltenen Verbundpulverteilchen ist folgende: Zur Erzielung eines Pulvers des superharten Materials der Schale, wie Diamant- oder Bornitridpulver, werden die Kerne des Verbundpulvers selektiv durch eine chemische Ätzung, gegebenenfalls nach Zerstoßen, aufgelöst, so daß das abgeschiedene superharte Material als Pulver zurückbleibt.

Es gibt zahllose Möglichkeiten, für die hier beschriebenen Kerne Substanzen auszuwählen, die sich chemisch wesentlich leichter auflösen als die superharten Stoffe, die auf ihnen abgeschieden wurden.

Superharte Diamantpulver, die auf diese Art und Weise gewonnen werden, könnten sich von normalen Natur- oder Hochdruck-Diamantpulvern folgendermaßen unterscheiden:

a) durch eine in diesem Diamantpulver - im Vergleich zu Hochdruck- oder Naturdiamanten - vorhandene, stark erhöhte Zahl der Gitterfehler;

b) aufgrund besonderer Kristallhabitusflächen, die nur oder vermehrt bei den plasmaabgeschiedenen Pulvern entstehen und bei Naturdiamanten und Hochdruckdiamanten nicht oder nur in seltenen Fällen auftreten;

beispielsweise sind in diesen Pulvern gewisse Anteile von Partikeln vorhanden, die einen fünfersymmetrischen Aufbau erkennen lassen und/oder kubische Oktaeder und/oder kubische Oktaeder mit einer Zwillingsebene und/oder Wulff-Polyeder und/oder Pentagondodekaeder und/oder diverse Zwillingsverwachsungen obiger Kristallmorphologien, darstellen;

c) durch unabsichtlich, verfahrensbedingt eingebrachte Dopingelemente, z. B. geringer Wasserstoffgehal-

8

EP 0 226 898 B1

te (größer als 0,001 % und deutlich kleiner als 10 %, vorzugsweise zwischen 0,01 und 5 %, insbesondere 0,5 bis 3 %) zumindest nach der Herstellung (d. h. ohne eine besondere Vakuum- und Wärmebehandlung);

d) durch absichtlich eingebrachte Dopingelemente (siehe Liste der Verunreinigungen in der obigen Beschreibung);

e) durch eine gegenüber dem Hochdruckdiamanten erniedrigte Aktivierungsenergie für die elektrische Leitfähigkeit, z. B. bei B-Zusatz im Diamanten von 0,013 eV gegenüber 0,15 bis 0,3 eV bei Hochdruckdiamant;

f) durch ein von Naturdiamant verschiedenes, an $C^{13}$ angereichertes Isotopenverhältnis von $C^{12}/C^{13}$.

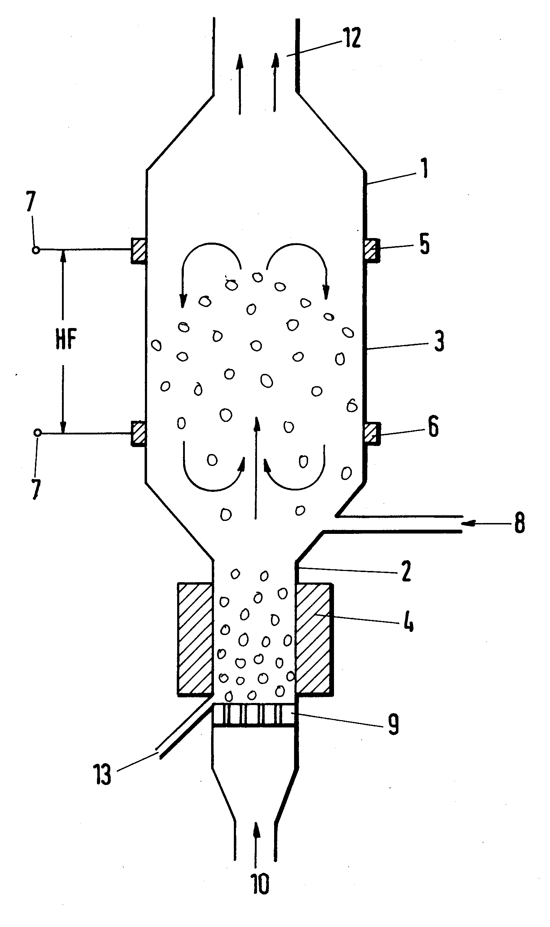

Die beigefügte Zeichnung zeigt beispielhalber in schematischer Darstellung eine Vorrichtung zur Durchführung eines Verfahrens zur Herstellung erfindungsgemäßer Verbundpulverteilchen.

Die in der Zeichnung dargestellte Vorrichtung besteht aus einem Reaktor 1 mit einem Vorheizabschnitt 2 und einem Reaktionsraum 3. Der Vorheizabschnitt 2 ist von einem Heizofen 4 umgeben und ist als Rohr ausgebildet, das sich zum Reaktionsabschnitt 3 hin erweitert. Das untere Ende des Vorheizabschnittes 2 bildet eine gasdurchlässige, für die eingefüllten Teilchen aber undurchlässige Verteilerplatte 9, wie eine Frittenplatte. Im Vorheizabschnitt 2 befindet sich ein feines Pulver (Kerne). Es kann zusätzlich ein gröberes neutrales Pulver eingeführt werden, das vornehmlich zur Wärmeübertragung dient und so grob ist, daß es nicht aus dem Raum 2 in den Raum 3 ausgeblasen wird.

In den unteren Bereich des Reaktionsabschnittes 3 mündet ein Zufuhrrohr für die Einführung von Kohlenstoffverbindungen, Borverbindungen oder anderer Reaktionsgase, während am unteren Ende des Reaktors 1 unterhalb der Verteilerplatte 9 eine Einrichtung zum Einführen von gewärmtem Reaktionsgas (z. B. Wasserstoffgas) mit oder ohne Zusatz eines Trägergases, wie z. B. Helium oder Argon, vorgesehen ist.

Der Reaktionsabschnitt 3 ist von zwei Wicklungen 5 und 6 umgeben, an die bei 7 eine Hochfrequenzspannung angelegt ist und durch die in dem Reaktionsabschnitt ein kaltes Gasplasma angeregt wird.

Das obere Ende des Reaktionsabschnittes 3 wird von einem Gasabzug gebildet, durch welchen auch die zu beschichtenden Teilchen eingefüllt werden. Am unteren Ende des Vorheizabschnittes 2 befindet sich eine während der Reaktion geschlossene Einrichtung 13 zum intermittierenden Ablassen fertiger beschichteter Verbundpulverteilchen.

Die in der Figur dargestellte Vorrichtung arbeitet im Falle der Diamantsynthese wie folgt: Durch das obere Ende 12 des Reaktors 1 wird das als Kerne dienende Pulver eingefüllt und fällt in den Vorheizabschnitt 2 auf die Verteilerplatte 9. Nunmehr wird durch den Einlaß 10 vorgewärmtes Wasserstoffgas allein oder im Gemisch mit Helium (Trägergas) in solcher Menge eingeführt, daß sich über der Verteilerplatte 9 in dem Vorheizabschnitt 2 eine dichte Wirbelschicht von Teilchen bildet. Diese wird durch den Ofen 4 geheizt.

Aus dem Vorheizabschnitt gelangen Pulverteilchen durch das aufwärts strömende Gas in den erweiterten Reaktionsabschnitt 3, wo sie in der Mitte des Gasraumes aufwärts strömen. Infolge der im Reaktionsabschnitt 3 herrschenden geringen Gasgeschwindigkeit fallen die mitgerissenen Teilchen im äußeren Raum des Reaktionsabschnittes 3 wieder nach unten. Durch die angelegte Hochfrequenzspannung und das dadurch erzeugte Feld wird ein Plasma angeregt. Gleichzeitig wird unter Umgehung des Vorheizabschnittes durch den Einlaß 8 eine gas-oder dampfförmige Kohlenstoffverbindung eingeführt. Diese Kohlenstoffverbindungen werden von dem Trägergas/Wasserstoffgas-Strom in den Reaktionsabschnitt mitgerissen und mischen sich in diesem, wobei in dem angeregten Plasma die Beschichtungsreaktionen sich abspielen. Die an der Quelle 7 angelegte Hochfrequenzspannung beträgt beispielsweise 80 MHz.

Die in dem Reaktionsabschnitt 3 beschichteten Teilchen fallen in den Vorheizabschnitt 2 und die dort befindliche dichte Wirbelschicht zurück. Zu erwähnen ist, daß die Teilchendichte der Wirbelschicht im Reaktionsabschnitt 3 erheblich geringer ist als die Teilchendichte in der Wirbelschicht des Vorheizabschnittes 2.

Die Reaktionsgase und das Trägergas verlassen im Gemisch miteinander den Reaktor 1 durch das obere Ende 12.

Die in der Zeichnung dargestellte Vorrichtung arbeitet ansatzweise. Wenn auf den Teilchen eine ausreichend dicke Schicht als Schale abgelagert ist, wird der Gasstrom durch den Einlaß 10 und den Einlaß 8 unterbrochen, und die fertigen Verbundteilchen werden durch den Auslaß 13 aus der Vorheizzone abgezogen.

Ein besonderer Vorteil dieser Anordnung besteht darin, daß die verbrauchten Gase nur kurzzeitig mit den Teilchen in Berührung stehen und rasch aus dem Reaktionsabschnitt entfernt werden, da, um diese sogenannte pneumatische Wirbelschicht aufrechtzuerhalten, eine hohe Gasströmungsgeschwindigkeit erforderlich ist.

Die Vorrichtung kann selbstverständlich auch kontinuierlich ausgebildet werden. Hierzu wird auf das

9

obere Ende 12 des Reaktors ein Zyklon aufgesetzt, der mitgerissene Teilchen von den verbrauchten Gasen abtrennt und über eine nicht gezeigte Rezyklierleitung zum unteren Bereich des Reaktionsabschnittes 3 zurückführt. Auch der Teilchenabzug durch den Austritt 13 kann dann kontinuierlich vorgenommen werden. Selbstverständlich können vorteilhaft auch mehrere derartige Anlagen in Reihe hintereinandergeschaltet werden, die nacheinander unterschiedliche oder gleiche Schichten auf dem Kern aufbringen. Es wird dadurch auch möglich, die mit der Vergröberung der Teilchen einhergehende Erhöhung der Sinkgeschwindigkeit bei gleichbleibender Gasströmungsgeschwindigkeit zu kompensieren. Die Trennung der größeren von den kleineren Teilchen erfolgt im Zyklon. Nur der Feinanteil geht in dem ersten Beschichtungsreaktor zurück, während die gröbere Fraktion in einem zweiten Reaktor mit anderen Strömungsgeschwindigkeiten weiter vergröbert wird. Damit kann jede Kornfraktion optimal beschichtet werden.

Beispiel 1

Versuchsbedingungen

100 g SiAlON, 20 $\mu$m mittlerer Korndurchmesser, gut kritallisiert, Wasserstoff mit 2 % Methan.

| | |
|---|---|
| Gasdurchflußgeschwindigkeit: | 200cm$^3$/min |
| Temperatur des Ta-Glühfadennetzes: | 2100 °C |
| Temperatur des Wirbelbettes: | 750 °C |
| Gasdruck: | 20 Torr (2,67 kPa) |
| Reaktionszeit: | 20 h |

Unterstützung des Wirbelbettes mit 50 % Fremdgas-Zusatz (entfällt bei Beispiel 1c und 1e), wodurch ca. 50 cm$^3$/min Gasfluß entsteht.

Versuchsdurchführung

Beschicken der Wirbelschicht-Apparatur mit SiAlON-Pulver Aufheizen des Wirbelbettes unter Wasserstoff, anschließend kurze Ätzperiode (10 min) mit reinem H$_2$ unter zeitweiser Zuhilfenahme eines glühenden Wolframdrahtnetzsystems anschließend Zumischen von Methan 0,5 % Versuchsdauer 20 h.

Beispiel 2

Verwendung von kub. Bornitrid als Kern anstelle von SiAlON, sonst analog Beispiel 1.

Beispiel 3

Herstellung eines mehrlagigen Superhartstoff-Verbundkörpers.
Versuchsbedingungen: zunächst von Beispiel 1.
Anschließend wird umgeschaltet auf eine andere Anregungsquelle mit Mikrowellen 4,8 GHz. Es werden neue Gase, bestehend aus 1 % Boran, 2 % Ammoniak, Rest Wasserstoff und geringen Zusätzen von Fluor eingebracht. Während 5 h wird superhartes Bornitrid abgeschieden.
Anschließend wird wieder rückgeschaltet auf die für Diamant nötigen Gase und abschließend durch 2 % Si$_2$H$_6$ mit 2 % Ammoniak und -Rest H$_2$ ohne besondere Anregung der Gase die Bildung einer Si$_3$N$_4$-Schicht erzielt.
Resultat: Wechselnde Schichtstruktur.
Kern: eingebrachtes SiAlON, darauf aufgebrachte Schichten aus Diamant, Bornitrid Und als äußerste Schicht Silicumnitrid. Schichtdicken in Funktion der Zeit unterschiedlich einstellbar, im vorliegenden Fall - wo bei jeweils 10 h pro Schicht beschichtet wurde - beträgt die Schichtdicke unter den gewählten Versuchsbedingungen für Diamant 4 $\mu$m, für Bornitrid 8 $\mu$m und für Siliciumnitrid 6 $\mu$m.

**Patentansprüche**

1. Verbundmaterialteilchen eines Durchmessers bis zu mehreren 1000 $\mu$m, bestehend aus einem inneren Kern und einer ihn als kontinuierliche Schicht umhüllenden, an ihm haftenden Schale, die wenigstens teilweise aus einem Superharten Stoff mit einer Härte von mehr als 3500 Vickers besteht, **dadurch**

**gekennzeichnet,** daß der innere Kern ein ein- oder polykristallines Teilchen aus einer superharten Modifikation von Bornitrid, ein bei Temperaturen bis 1000 °C mit Kohlenstoff und/oder Bornitrid nicht oder höchstens wenig reagierender und sie bis zu dieser Temperatur nicht oder höchstens langsam auflösender Hartstoff, bestehend aus einem Karbid, Nitrid, einem Borid, einem Phosphid, einem Sulfid, einem Silicid, einem Oxid (ausgenommen reines $\alpha$-$Al_2O_3$), Oxynitrid, Oxycarbid, Oxycarbonitrid, einer NOSC (= Non-Oxide-Silicon-Ceramic) oder SiAlON oder ein anorganischer Stoff normaler Härte, der bei Temperaturen bis zu 1000 °C mit Kohlenstoff und/oder BN nicht oder nur langsam reagiert oder diese nicht oder nur wenig auflöst, eine mehr-phasige Mischung bzw. ein Mischkristall dieser Stoffe oder ein festes Reaktionsprodukt, das als heterogener Kristallkeim wirkt, ist und der superharte Stoff der Schale von dem Kern verschieden ist.

2. Verbundmaterialteilchen nach Anspruch 1, **dadurch gekennzeichnet,** daß der superharte Stoff der Schale aus Modifikationen des Kohlenstoffs, Bornitrid oder anderen Phasen aus dem ternären System B, N, C besteht, wobei diese Elemente als Hauptbestandteile auftreten.

3. Verbundmaterialteilchen nach Anspruch 1 oder 2, **dadurch gekennzeichnet,** daß die äußere Schale aus mehreren Schichten besteht, wovon mindestens eine aus ein- oder polykristallinem Diamant und/oder einer anderen superharten Kohlenstoffmodifikation oder einer superharten Modifikation von Bornitrid besteht, wobei dieser superharte Stoff eine zusammenhängende anhaftende Schicht bildet.

4. Verbundmaterialteilchen nach einem der Ansprüche 1 bis 3, **dadurch gekennzeichnet,** daß der Kern so klein ausgebildet ist, daß er als heterogener Keim für die Kristallisation des Superhartstoffes aus der damit übersättigten Gasphase anzusehen ist.

5. Verfahren zur Herstellung von Verbundmaterialteilchen nach einem der Ansprüche 1 bis 4, **dadurch gekennzeichnet,** daß die Kerne in einem chemischen Gasphasenabscheidungsverfahren (CVD-Verfahren) mit Hilfe eines Gasstromes in Bewegung gehalten, bei einer Temperatur zwischen 500 und 1200 °C und einem Druck unter 66,661 kPa (500 Torr) beschichtet werden, wobei der Gasstrom aus $CH_4$ oder einer anderen gas-oder dampfförmigen Kohlenstoffverbindung und Wasserstoff mit oder ohne Zusatz von Edelgasen und/oder aus einer gas- oder dampfförmigen Borverbindung oder einer Bor und Stickstoff enthaltenden Verbindung und/oder Wasserstoff und/oder Stickstoff und/oder Halogen und/oder deren Verbindungen mit oder ohne Edelgaszusatz besteht, und in diesen Fällen wenigstens eines der Gase durch ein physikalisches oder chemisches Verfahren in einen angeregten Zustand gebracht wurde und das Gasgemisch in einem CVD-Reaktor, der kleine Festkörper in Schwebe hält, mit einem pulverförmigen Substrat in Konktakt gebracht wird.

6. Verfahren nach Anspruch 5, **dadurch gekennzeichnet,** daß der Gasstrom durch
   a) eine stark erhitzte glühende Oberfläche eines festen Stoffes, und/oder
   b) eine Gasentladung im Unterdruck, ausgelöst von Gleich-oder Wechselströmen, und/oder
   c) ein Plasma, hergestellt durch elektromagnetische Wellen, und/oder
   d) Ultraschall bzw. Druckwechsel und/oder
   e) ein chemisches Verfahren unter Zersetzen mit Licht oder durch chemische Reaktion
   angeregt wird, wobei in allen angeführten Fällen wenigstens eines der eingesetzten Gase vor oder während der Berührung mit dem zu umhüllenden Kern teilweise in einen angeregten Zustand versetzt wird und kurzlebige und sich spontan in beständigere Stoffe umwandelnde Radikale und/oder atomare Spezien der eingesetzten Gase und/oder von Verbindungen, die sich aus den Gasgemischen bilden können, gebildet werden.

7. Vorrichtung zur Durchführung des Verfahrens nach Anspruch 5 oder 6 mit einem beheizten Reaktor, Einrichtungen zum Einführen von Reaktionsgasen, einer Einrichtung zur Einführung von Gas zur Bildung einer Wirbelschicht in dem Reaktor und Einrichtungen, die den Gasstrom in einen angeregten Zustand versetzen, **dadurch gekennzeichnet,** daß der Reaktor (1) einen unteren Vorheizabschnitt (2) und einen oberen, daran anschließenden Reaktionsabschnitt (3) besitzt, daß die Einrichtung (10) zur Einführung von Gas so angeordnet ist, daß die dichte Wirbelschicht in dem Vorheizabschnitt (2) aufrechterhalten wird und von diesem Gas Pulverteilchen aus dem Vorheizabschnitt (2) in den Reaktionsabschnitt (3) überführt werden, und daß die Einrichtungen (5, 6, 7) zur Anregung des Gasstromes so angeordnet sind, daß der heiße Gasstrom in dem Reaktionsabschnitt in den angeregten Zustand versetzt wird.

EP 0 226 898 B1

**8.** Vorrichtung nach Anspruch 7, **dadurch gekennzeichnet,** daß der Reaktionsabschnitt (3) des Reaktors (1) einen größeren Durchmesser als der Vorheizabschnitt (2) hat.

**9.** Verfahren zur Herstellung eines Pulvers aus einem superharten Stoff, **dadurch gekennzeichnet,** daß man Verbundpulverteilchen nach einem der Ansprüche 1 bis 4, gegebenenfalls nach vorhergehendem Zerkleinern der Teichen, einer chemischen Reaktion unterzieht, die die Kerne der Verbundpulverteilchen auflöst und den superharten Stoff im wesentlichen nicht angreift.

**10.** Verwendung von Verbundmaterialteilchen nach einem der Ansprüche 1 bis 4 zur Herstellung von Sinterkörpern.

**11.** Verwendung von Verbundmaterialteilchen mit einer Schale, bei der in den Korngrenzen der superharten polykristallinen Schicht die entsprechenden stabilen Phasen eingelagert sind, nach Anspruch 10 unter Hochdruckumwandlung, die die stabilen Phasen in die superharten Modifikation transformiert.

**Claims**

**1.** Composite material particles with a diameter of up to several thousand $\mu$m, comprising an inner core and a shell adhering to the same and enveloping it as a continuous coating and which at least partly comprises a superhard material with a hardness of more than 3500 Vickers, characterized in that the inner core is a monocrystalline or polycrystalline particle of a superhard modification of boron nitride, a hard material reacting very slightly or not at all at temperatures up to 1000°C with carbon and/or boron nitride and not or at the most slowly dissolving the same up to said temperature, comprising carbide, nitride, a boride, a phosphide, a sulphide, a silicide, an oxide (except pure $\alpha$-Al$_2$O$_3$), oxinitride, oxicarbide, oxicarbonitride, a NOSC (= Non-Oxide-Silicon-Ceramic) or SiAlON or an inorganic material of normal hardness, which, at temperatures up to 1000°C, only react slowly or not at all with carbon and/or BN or does not or only slightly dissolves the same, a multiphase mixture or a mixed crystal of these substances or a solid reaction product acting as a heterogeneous crystal nucleus and the superhard material of the shell differs from the core.

**2.** Composite material particles according to claim 1, characterized in that the superhard material of the shell comprises modifications of carbon, boron nitride or other phases from the ternary system B, N, C, in which said elements occur as the main constituents.

**3.** Composite material particles according to claims 1 or 2, characterized in that the outer shell comprises several coatings, whereof at least one comprises a monocrystalline or polycrystalline diamond and/or some other superhard carbon modification, or a superhard modification of boron nitride, said superhard material forming a cohesive, adhering coating.

**4.** Composite material particles according to one of the claims 1 to 3, characterized in that the core is so small that it is to be looked upon as a heterogeneous nucleus for the crystallization of the superhard material from the gas phase supersaturated therewith.

**5.** Process for the production of composite material particles according to one of the claims 1 to 4, characterized in that the cores are kept moving with the aid of a gas flow in a chemical gas phase deposition process (CVD process), are coated at a temperature between 500 and 1200°C and a pressure under 66.661 kPa (500 Torr), in which the gas flow consists of CH$_4$ or some other gaseous or vaporous carbon compound and hydrogen with or without the addition of inert gases and/or a gaseous or vaporous boron compound or a boron and nitrogen-containing compound and/or hydrogen and/or nitrogen and/or halogen and/or compounds thereof with or without inert gas addition and in these cases at least one of the gases is brought into an excited state by a physical or chemical process and the gaseous mixture is brought into contact with a pulverulent substrate in a CVD reactor, which keeps small solids suspended.

**6.** Process according to claim 5, characterized in that the gas flow is excited by
   a) a strongly heated glowing surface of a solid substance and/or
   b) a gas discharge in vacuo initiated by direct or alternating currents and/or
   c) a plasma produced by electromagnetic waves and/or

EP 0 226 898 B1

d) ultrasonic or pressure changes and/or
e) a chemical process with decomposition by light or by chemical reaction,
and in all the indicated cases at least one of the gases introduced before or during contact with the core to be coated is partly brought into an excited state and short-life radicals converted spontaneously into more resistant materials and/or atomic species of the gases introduced and/or compounds which can form from the gaseous mixtures are formed.

7. Apparatus for performing the process according to claims 5 or 6 with a heated reactor, devices for introducing reaction gases, a device for introducing gas for forming a fluidized bed in the reactor and devices bringing the gas flow into an excited state, characterized in that the reactor (1) has a lower preheating section (2) and an upper reaction section (3) following onto the same, that the device (10) for introducing gas is positioned in such a way that the dense fluidized bed in the preheating section (2) is maintained and from said gas powder particles are transferred from the preheating section (2) into the reaction section (3) and that the devices (5, 6, 7) for exciting the gas flow are positioned in such a way that the hot gas flow is brought into the excited state in the reaction section.

8. Apparatus according to claim 7, characterized in that the reaction section (3) of the reactor has a larger diameter than the preheating section (2).

9. Process for producing a powder from a superhard material, characterized in that the composite powder particles according to one of the claims 1 to 4, optionally following preceding comminution of the particles, undergo a chemical reaction, which dissolves the cores of the composite powder particles and essentially does not attack the superhard material.

10. Use of the composite material particles according to one of the claims 1 to 4 for producing sintered articles.

11. Use of composite material particles with a shell, in which the corresponding stable phases are incorporated into the grain boundaries of the superhard, polycrystalline layer, according to claim 10, accompanied by high pressure transformation transforming the stable phases into the superhard modification.

**Revendications**

1. Particule de matière composite ayant un diamétre pouvant atteindre plusieurs 1 000 $\mu$m , consistant en un noyau interne et en une peau qui y adhère et l'entoure sous forme d'une couche continue , qui consiste au moins en partie en une substance superdure ayant une dureté supérieure à 3 500 unités Vickers, particule caractérisée en ce que le noyau interne est une particule monocristalline ou polycristalline en une forme superdure de nitrure de bore , une matière dure ne réagissant pas ou ne réagissant qu'un peu,au maximum, avec le carbone et/ou avec le nitrure de bore à des températures allant jusqu'à 1 000 ° C et ne les dissolvant pas ou ne les dissolvant que lentement,au maximum, à cette température et consistant en un carbure, un nitrure, un borure , un phosphure , un sulfure , un siliciure , un oxyde ( à l'exception de $Al_2O_3$-$\alpha$ pur) , un oxynitrure , oxycarbure , oxycarbonitrure , un "NOSC" ( = "Non-Oxide-Silicon-Ceramic";céramique qui n'est pas de l'oxyde de silicium) ou SiAlON ou une matière minérale de dureté normale ,qui ne réagit pas avec le carbone et/ou avec BN ou ne réagit que lentement avec eux ou ne les dissout pas du tout ou lentement seulement à des températures allant jusqu'à 1 000 ° C , un mélange à plusieurs phases ou un cristal mixte de ces matières ou un produit solide de réaction,agissant comme germe cristallin hétérogène , et la substance superdure de la peau est différente du noyau .

2. Particule de matière composite selon la revendication 1 , caractérisée en ce que lsubstance superdure de la peau consiste en formes du carbone , du nitrure de bore ou en d'autres phases du système ternaire B , N , C , dans lesquelles ces éléments apparaissent comme constituants principaux .

3. Particule de matière composite selon la revendication 1 ou 2, caractérisée en ce que la peau externe consiste en plusieurs couches , dont au moins une consiste en diamant mono- ou polycristallin et/ou en une autre forme superdure de carbone ou en une forme superdure de nitrure de bore , cette substance superdure formant une couche cohésive et adhérente .

13

**4.** Particule de matière composite selon l'une des revendications 1 à 3 , caractérisée en ce que le noyau est formé si petit,qu'il est à considérer comme germe hétérogène pour la cristallisation de la substance superdure à partir de la phase gazeuse sursaturée en cette substance .

**5.** Procédé de préparation des particules de matière composite selon l'une des revendications 1 à 4 , caractérisée en ce que,dans un procédé chimique de dépôt en phase gazeuse (Procédé CVD ["chemical vapour deposition"]), les noyaux sont maintenus en mouvement à l'aide d'un courant gazeux , ils sont enduits à une température comprise entre 500 et 1 200 ° C et sous une pression de 66,66 kPa (500 torrs) , le courant gazeux consistant en $CH_4$ ou en un autre composé de carbone et sous forme de gaz ou de vapeur et en hydrogène ,avec ou sans addition de gaz rares et/ou en un composé de bore sous forme de gaz ou de vapeur ou en un composé contenant du bore et de l'azote et/ou en hydrogène et/ou en azote et/ou en un halogène et/ou en leurs composés avec ou sans addition de gaz rare, et l'un au moins des gaz étant alors porté par un procédé physique ou chimique à un état excité, et le mélange gazeux étant mis en contact, dans un réacteur pour CVD , contenant de petits solides en suspension , avec un substrat pulvérulent .

**6.** Procédé selon la revendication 5 , caractérisé en ce que le courant gazeux est excité par
(a) une surface incandescente, fortement chauffée , d'un solide; et/ou
(b) une décharge, déclenchée par des courants continus ou alternatifs, dans du gaz en dépression ; et/ou
(c) un plasma , produit par des ondes électromagnétiques, et/ou
(d) des ultrasons ou une variation de pression, et/ou
(e) un procédé chimique,avec décomposition par la lumière ou par réaction chimique,
au moins l'un des gaz utilisés étant , dans tous les cas indiqués , mis partiellement en un état d'excitation avant ou pendant le contact avec le noyau à enrober et il se forme des radicaux et/ou des espèces atomiques ( à courte durée de vie et se transformant spontanément en substances plus stables) des gaz utilisés et/ou de composés pouvant se former à partir de mélanges gazeux .

**7.** Appareil pour la conduite du procédé selon la revendication 5 ou 6 , cet appareil comportant un réacteur chauffé , des dispositifs pour introduire des gaz pour une réaction, un dispositif pour introduire du gaz pour former une couche fluidisée dans le réacteur,et des dispositifs qui mettent le courant gazeux en état d'excitation , appareil caractérisé en ce que le réacteur (1) comporte une partie (2) inférieure de préchauffage et une partie (3) supérieure de réaction,qui y fait suite; en ce que le dispositif (10) d'introduction de gaz est agencé de manière à maintenir la couche fluidisée épaisse dans la partie (2) de préchauffage et que des particules pulvérulentes de ce gaz soient transférées de la partie (2) de préchauffage à la partie (3) de réaction;et en ce que les dispositifs (5,6,7) pour exciter le courant gazeux sont agencés de manière que le courant gazeux chaud soit mis à l'état excité dans la partie de réaction ( du réacteur) .

**8.** Appareil selon la revendication 7 , caractérisé en ce que la partie (3) de réaction,du réacteur (1),a un plus grand diamètre que la partie (2) de préchauffage .

**9.** Procédé pour produire une poudre à partir d'une substance superdure , caractérisé en ce qu'on soumet des particules d'une poudre composite selon l'une des revendications 1 à 4 , éventuellement après une fragmentation préliminaire des particules , à une réaction chimique,qui dégage les noyaux des particules de la poudre composite et n'attaque essentiellement pas la substance superdure .

**10.** Utilisation de particules de matière composite selon l'une des revendications 1 à 4 ,pour la production de corps frittés .

**11.** Utilisation de particules d'une matière composite comportant une peau , dans laquelle les phases stables correspondantes sont emmagasinées dans les limites des grains de la couche polycristalline superdure, selon la revendication 10, avec transformation sous pression élevée,faisant passer les phases stables à la variante superdure .

14